# EUROPÄISCHE PATENTANMELDUNG

(11) **EP 4 530 123 A1**
(43) Veröffentlichungstag der Anmeldung: **02.04.2025**
(21) Anmeldenummer: 24199233.8
(22) Anmeldetag: 09.09.2024
(51) Int. Cl.: B60L 53/62, G01R 19/00, H02H 7/26

(54) **LADEVORRICHTUNG FÜR EIN ELEKTROFAHRZEUG UND VERFAHREN ZUM LADEN EINES ELEKTROFAHRZEUGS**

(30) Priorität: 28.09.2023 DE 102023209506
(71) Anmelder: Siemens Aktiengesellschaft, 80333 München (DE)
(72) Erfinder: Martel, Jean-Mary, 93105 Tegernheim (DE)
(74) Vertreter: Siemens Patent Attorneys

(57) **Zusammenfassung**

Die Erfindung betrifft eine Ladevorrichtung (1) für ein Elektrofahrzeug (2) und ein Verfahren zum Laden eines Elektrofahrzeugs (2). Die Ladevorrichtung (1) umfasst wenigstens einen Ladestecker (3), einen Stromrichter (5), zwischen den Stromrichter (5) und den Ladestecker (3) geschaltete Stromsensor (6) und Schalter (7) sowie eine Steuereinheit (8). Der Stromrichter (5) ist mit dem Ladestecker (3) und einem Versorgungsanschluss (4) der Ladevorrichtung verbunden und dazu ausgebildet, von dem Versorgungsanschluss (4) elektrische Energie zu empfangen und gemäß einer Anforderung des Elektrofahrzeugs (2) an den Ladestecker (3) auszugeben. Der Stromsensor (6) ist dazu ausgebildet, einen zwischen Stromrichter (5) und Ladestecker (3) fließenden Strom zu messen und als Strommesswert auszugeben. Der Schalter (7) ist dazu ausgebildet, den von dem Stromrichter (5) zum Ladestecker (3) fließenden Strom abzuschalten. Die Steuereinheit (8) ist mit dem Stromsensor (6) und dem Schalter (7) verbunden und erfindungsgemäß dazu ausgebildet, ein Lichtbogenereignis anhand einer Reihe von Strommesswerten zu detektieren und bei Detektieren des Lichtbogenereignisses den Schalter (7) zum Abschalten des von dem Stromrichter zum Ladestecker (3) fließenden Stroms anzusteuern.

Das erfindungsgemäße Verfahren weist wenigstens folgende Schritte auf:
-- Messen eines an das Elektrofahrzeug (2) abgegebenen Ladestromes, um eine Reihe von Strommesswerten zu erhalten;
-- Detektieren eines Lichtbogenereignisses anhand der Reihe von Strommesswerten; und
-- Abschalten des Ladestromes, wenn ein Lichtbogenereignis detektiert wird.

## Beschreibung

### Technisches Gebiet

Die Erfindung betrifft eine Ladevorrichtung für ein Elektrofahrzeug und ein Verfahren zum Laden eines Elektrofahrzeugs.

### Technischer Hintergrund

Im Zuge der angestrebten Dekarbonisierung des Kraftfahrzeugverkehrs werden Kraftfahrzeuge zunehmend elektrifiziert. Solche Elektrofahrzeuge müssen regelmäßig durch Ladevorrichtungen aufgeladen werden. Hierzu wird üblicherweise das Elektrofahrzeug über eine Steckverbindung an die Ladevorrichtung angeschlossen. Am Elektrofahrzeug ist eine Ladebuchse angeordnet, die dazu vorgesehen ist, einen Ladestecker der Ladevorrichtung aufzunehmen.

Die Ladevorrichtung ist eine leistungselektrische Einrichtung. Grundsätzlich sollen Personen- und Sachschäden beim Betrieb und durch den Betrieb der Ladevorrichtung vermieden werden.

Es ist daher Aufgabe der Erfindung eine sicher betreibbare Ladevorrichtung und ein sicheres Betriebsverfahren für eine Ladevorrichtung einzuführen.

Die Erfindung löst diese Aufgabe durch die Ladevorrichtung von Anspruch 1 und das Verfahren von Anspruch 11. Bevorzugte Ausführungen der Erfindung sind in den Unteransprüchen angegeben.

### Zusammenfassung der Erfindung

Ein erster Aspekt der Erfindung betrifft eine Ladevorrichtung für ein Elektrofahrzeug. Die Ladevorrichtung umfasst wenigstens einen Ladestecker, einen mit dem Ladestecker und einem Versorgungsanschluss der Ladevorrichtung verbundenen Stromrichter, einen zwischen den Stromrichter und den Ladestecker geschalteten Stromsensor, einen Schalter und eine Steuereinheit. Der Ladestecker ist dazu ausgebildet, an das Elektrofahrzeug angeschlossen zu werden. Der Stromrichter ist mit dem Ladestecker und einem Versorgungsanschluss der Ladevorrichtung verbunden und dazu ausgebildet, von dem Versorgungsanschluss elektrische Energie zu empfangen und gemäß einer Anforderung des Elektrofahrzeugs an den Ladestecker auszugeben. Der Stromsensor ist zwischen den Stromrichter und den Ladestecker geschaltet und dazu ausgebildet, einen zwischen Stromrichter und Ladestecker fließenden Strom zu messen und als Strommesswert auszugeben. Der Schalter ist dazu ausgebildet, den von dem Stromrichter zum Ladestecker fließenden Strom abzuschalten. Die Steuereinheit ist mit dem Stromsensor und dem Schalter verbunden. Erfindungsgemäß ist die Steuereinheit dazu ausgebildet, ein Lichtbogenereignis anhand einer Reihe von Strommesswerten zu detektieren und bei Detektieren des Lichtbogenereignisses den Schalter zum Abschalten des von dem Stromrichter zum Ladestecker fließenden Stroms anzusteuern.

Die Erfindung beruht auf der Erkenntnis und schließt diese mit ein, dass ein Lichtbogenereignis an der Steckverbindung zwischen Ladestecker und Elektrofahrzeug anhand einer Reihe von Strommesswerten detektiert werden kann. Ein solches Lichtbogenereignis kann durch eine zu lose Verbindung zwischen Ladestecker und Ladebuchse verursacht werden, was wiederum auf Deformierungen des Ladesteckers aufgrund unsachgemäßer Handhabung zurückzuführen sein kann. Das Lichtbogenereignis führt zu einer lokalen Erhitzung, die dabei entstehenden Temperaturen können zu einer Oxidierung der Leiteroberfläche am Ort des Lichtbogens und wegen der Wärmeleitung des Metalls des Leiters auch an umliegenden Isolatoren wie dem Kabelmantel führen. Infolge der Oxidierung steigt der elektrische Widerstand, was wiederum eine Erhöhung des Wärmeeintrags aufgrund eines fließenden Stroms bedingt. Es folgt ein sich selbst beschleunigender Prozess, der schließlich zu einer so großen Hitzeentwicklung führen kann, dass eine Selbstentzündung von Ladestecker, Ladekabel und Elektrofahrzeug erfolgt. Die Ladevorrichtung der Erfindung kann ein Lichtbogenereignis detektieren und bei einem Vorliegen eines solchen Lichtbogenereignisses eine Abschaltung des Ladestroms bewirken. Zusätzlich kann die Ladevorrichtung ein Wartungssignal ausgeben, so dass von einer Leitstelle oder dergleichen eine Wartung der Ladevorrichtung veranlasst werden kann, bei der beispielsweise ein beschädigter oder unerwünscht stark oxidierter Ladestecker ausgetauscht oder repariert werden kann.

Besonders bevorzugt ist die Steuereinheit dazu ausgebildet, die Strommesswerte der Reihe von Strommesswerten mit einem Stromschwellwert zu vergleichen und das Lichtbogenereignis anhand einer Rate von Überschreitungen und/oder Unterschreitungen des Stromschwellwertes zu detektieren. Der Stromschwellwert kann dabei in Abhängigkeit von einer Leistungsanforderung des Elektrofahrzeugs gesetzt werden. Insbesondere bei einem Gleichspannungsladevorgang verhandeln Ladevorrichtung und Elektrofahrzeug die elektrischen Parameter des Ladevorgangs, so dass hieraus ein Stromschwellwert abgeleitet werden kann, beispielsweise indem der Stromschwellwert auf 90 Prozent des erwarteten Ladestroms oder einen anderen proportionalen Wert gesetzt wird, wobei der Stromschwellwert so weit unter dem erwarteten Ladestrom gewählt werden sollte, dass eine betriebsübliche Welligkeit des Ladestroms aufgrund interner Schaltvorgänge des Stromrichters oder auch des Elektrofahrzeugs nicht zu einer Fehldetektion führen. Der Stromschwellwert kann aber auch aus einem gleitenden Mittelwert des Ladestroms adaptiv abgeleitet werden oder gemäß vorbekannten Ladeprofilen gewählt werden.

Als Überschreitungen und Unterschreitungen werden hier insbesondere Kreuzungen von Ladestrom und Stromschwellwert verstanden. Eine Überschreitung des Stromschwellwertes ist dann ein Ereignis, bei dem der Ladestrom von unterhalb des Stromschwellwertes auf oberhalb des Stromschwellwertes steigt; eine Unterschreitung dementsprechend eines, bei dem der Ladestrom von oberhalb des Stromschwellwertes auf unterhalb des Stromschwellwertes fällt. Solche Ereignisse können gelegentlich aufgrund von Schaltvorgängen und dergleichen auftreten. Bei Vorliegen eines Lichtbogenereignisses zeigt der fließende Strom hingegen ständige, zufällig wirkende Schwankungen mit großer Schwankungsweite, die häufig mehrere Male pro Sekunde auftreten. Dementsprechend kann eine hohe Rate von Überschreitungen und/oder Unterschreitungen des Stromschwellwertes als Erkennungsmerkmal eines Lichtbogenereignisses herangezogen werden. Die Rate von Überschreitungen und/oder Unterschreitungen des Stromschwellwertes ist dabei ein einfach zu bestimmendes Kriterium, das aussagekräftiger ist als beispielsweise eine Bestimmung der Zeitdauern oder zeitlichen Anteile, in denen der Ladestrom unterhalb oder oberhalb des Stromschwellwertes liegt.

Der Stromsensor ist angesichts des hochdynamischen Verhaltens des Fehlerbildes des Störlichtbogenereignisses bevorzugt dazu ausgebildet, den Ladestrom wenigstens einmal pro Sekunde, besser wenigstens zehnmal pro Sekunde oder mehr, zu messen.

Eine Überschreitung kann von der Steuereinheit insbesondere dann erkannt werden, wenn ein vorangehender Strommesswert der Reihe von Strommesswerten kleiner als der Stromschwellwert oder gleich dem Stromschwellwert ist und ein dem vorrangehenden Strommesswert der Reihe von Strommesswerten unmittelbar nachfolgender Strommesswert größer als der Stromschwellwert ist. Dementsprechend kann eine Unterschreitung insbesondere dann vorliegen, wenn ein vorrangehender Strommesswert der Reihe von Strommesswerten größer als der Stromschwellwert oder gleich dem Stromschwellwert ist und ein dem vorrangehenden Strommesswert der Reihe von Strommesswerten unmittelbar nachfolgender Strommesswert kleiner als der Stromschwellwert ist. Diese Erkennung kann programmtechnisch besonders einfach in einem Mikrokontroller oder dergleichen implementiert werden.

Die Steuereinheit ist vorzugsweise dazu ausgebildet, das Lichtbogenereignis unter einer ersten Bedingung zu detektieren, wobei die erste Bedingung erfüllt ist, wenn die Reihe von Strommesswerten eine erste Anzahl von Überschreitungen und/oder Unterschreitungen des Stromschwellwertes innerhalb einer ersten Zeitspanne aufweisen. Beispielsweise können die erste Anzahl zwischen 20 und 80 Überschreitungen und/oder Unterschreitungen und die erste Zeitspanne zwischen 5 und 20 Sekunden gewählt werden.

Die Steuereinheit kann dabei außerdem dazu ausgebildet sein, das Lichtbogenereignis unter einer zweiten Bedingung zu detektieren, wobei die zweite Bedingung erfüllt ist, wenn die Reihe von Strommesswerten eine von der ersten Anzahl verschiedene zweite Anzahl von Überschreitungen und/oder Unterschreitungen des Stromschwellwertes innerhalb einer von der ersten Zeitspanne verschiedenen zweiten Zeitspanne aufweisen. Die zweite Anzahl könnte hierbei beispielsweise zwischen 100 und 250 Überschreitungen und/oder Unterschreitungen und die zweite Zeitspanne zwischen 20 und 100 Sekunden gewählt werden.

Es ist dabei möglich, dass die Erfüllung nur einer der beiden Bedingungen, also entweder der ersten Bedingung oder der zweiten Bedingung, dazu führt, dass die Steuereinheit das Lichtbogenereignis detektiert. Dies führt zu einer besonders schnellen Detektion des Lichtbogenereignisses. Alternativ kann die Steuereinheit das Lichtbogenereignis auch nur dann detektieren, wenn die erste Bedingung und die zweite Bedingung beide erfüllt sind. In diesem Fall können Fehldetektionen weitgehend vermieden werden.

In einer besonders bevorzugten Ausführungsform der erfindungsgemäßen Ladevorrichtung kann die Steuereinheit dazu ausgebildet sein, einen Zähler bei einem Vorliegen einer Überschreitung und/oder einer Unterschreitung des Stromschwellwertes zu inkrementieren und den Zähler nach Verstreichen einer vorbestimmten Zeitspanne zu dekrementieren. Dabei ist die Steuereinheit dazu ausgebildet, das Lichtbogenereignis zu detektieren, wenn der Zähler einen Zählerschwellwert erreicht. Hierbei handelt es sich um eine besonders einfach zu implementierende Umsetzung der Erfindung. Der Zählerschwellwert wird dabei nur erreicht und das Lichtbogenereignis detektiert, wenn die Rate der Über- und/oder Unterschreitungen des Stromschwellwertes über eine längere Zeitspanne über der Rate der Dekrementierungen des Zählers aufgrund des wiederholten Verstreichens der vorbestimmten Zeitspanne liegt. Durch diese Vorgehensweise wird ein "weiches" Kriterium für die Detektion eines Lichtbogenereignisses geschaffen. Beispielsweise kann der Zähler einmal in der Sekunde um einen Wert von 5 dekrementiert und der Zählerschwellwert als 300 gewählt werden. Dann wird ein Lichtbogenereignis detektiert, wenn es zu 350 Über- und/oder Unterschreitungen innerhalb von 10 Sekunden oder zu 550 Über- und/oder Unterschreitungen innerhalb von 50 Sekunden kommt usw.

Die Ladevorrichtung kann mit einem zwischen Stromsensor und Steuereinheit geschalteten Filter ausgestattet sein, wobei das Filter dazu ausgebildet ist, von dem Stromsensor Strommesswerte zu empfangen, die empfangenen Strommesswerte zu filtern und die gefilterten Strommesswerte an die Steuereinheit auszugeben. Das Filter kann beispielsweise ein Hochpass- oder Bandpassfilter sein, das innerhalb eines für Lichtbogenereignisse typischen Frequenzbandes durchlässig ist. Ebenso ist es vorstellbar, das Filter als Schmitt-Trigger mit einer Schalthysterese auszuführen.

Ein zweiter Erfindungsaspekt betrifft ein Verfahren zum Laden eines Elektrofahrzeugs, mit den Schritten:
-- Messen eines an das Elektrofahrzeug abgegebenen Ladestromes, um eine Reihe von Strommesswerten zu erhalten;
-- Detektieren eines Lichtbogenereignisses anhand der Reihe von Strommesswerten; und
-- Abschalten des Ladestromes, wenn ein Lichtbogenereignis detektiert wird.

Die für die Ladevorrichtung beschriebenen bevorzugten Ausführungsformen können unmittelbar auf das erfindungsgemäße Verfahren übertragen werden, was nachfolgend kurz dargestellt werden soll. Es gelten dabei dieselben Erwägungen, Weiterbildungen, Parameter, Grenzwerte, Bedingungen und Vorteile wie oben für die Ladevorrichtung angegeben.

Bei besonders bevorzugten Ausführungsformen des erfindungsgemäßen Verfahrens ist ein zusätzlicher Schritt des Vergleichens der Strommesswerte der Reihe von Strommesswerten mit einem Stromschwellwert und ein Schritt des Detektierens des Lichtbogenereignisses anhand einer Rate von Überschreitungen und/oder Unterschreitungen des Stromschwellwertes.

Beispielsweise kann eine Überschreitung detektiert werden, wenn ein vorrangehender Strommesswert der Reihe von Strommesswerten kleiner als der Stromschwellwert oder gleich dem Stromschwellwert ist und ein dem vorrangehenden Strommesswert der Reihe von Strommesswerten unmittelbar nachfolgender Strommesswert größer als der Stromschwellwert ist.

Eine Unterschreitung kann detektiert werden, wenn ein vorrangehender Strommesswert der Reihe von Strommesswerten größer als der Stromschwellwert oder gleich dem Stromschwellwert ist und ein dem vorrangehenden Strommesswert der Reihe von Strommesswerten unmittelbar nachfolgender Strommesswert kleiner als der Stromschwellwert ist.

Das Lichtbogenereignis kann unter einer ersten Bedingung detektiert werden, die dann erfüllt sein kann, wenn die Reihe von Strommesswerten eine erste Anzahl von Überschreitungen und/oder Unterschreitungen des Stromschwellwertes innerhalb einer ersten Zeitspanne aufweisen.

Zusätzlich kann eine zweite Bedingung für das Detektieren des Lichtbogenereignisses vorgesehen sein, die dann erfüllt ist, wenn die Reihe von Strommesswerten eine von der ersten Anzahl verschiedene zweite Anzahl von Überschreitungen und/oder Unterschreitungen des Stromschwellwertes innerhalb einer von der ersten Zeitspanne verschiedenen zweiten Zeitspanne aufweisen.

Dabei kann als zusätzliche Voraussetzung für ein Detektieren des Lichtbogenereignisses vorgesehen sein, dass die erste Bedingung und die zweite Bedingung erfüllt sein müssen.

Bei besonders bevorzugten Ausführungen des erfindungsgemäßen Verfahrens sind ein Schritt des Inkrementierens eines Zählers bei einem Vorliegen einer Überschreitung und/oder einer Unterschreitung des Stromschwellwertes sowie ein Schritt des Dekrementierens des Zählers nach Verstreichen einer vorbestimmten Zeitspanne vorgesehen. Das Detektieren des Lichtbogenereignisses erfolgt in diesem Fall, wenn der Zähler einen Zählerschwellwert erreicht.

Allgemein kann vorgesehen sein, von dem Stromsensor gemessene Strommesswerte einem Schritt des Filterns zu unterziehen und die gefilterten Strommesswerte für die oben beschriebenen Schritten des Detektierens des Lichtbogenereignisses zu verwenden. Im Schritt des Filterns kann beispielsweise eine Schalthysterese auf die gemessenen Strommesswerte angewendet werden.

### Kurzbeschreibung der Figuren

Die Erfindung wird nachfolgend anhand von Abbildungen von Ausführungsbeispielen näher beschrieben. Es zeigen:
Fig. 1 ein Ausführungsbeispiel einer erfindungsgemäßen Ladevorrichtung;
Fig. 2 ein Ausführungsbeispiel eines erfindungsgemäßen Verfahrens zum Laden eines Elektrofahrzeugs;
Fig. 3 ein beispielhaftes Transientendiagramm des an ein Elektrofahrzeug abgegebenen Ladestroms I, und
Fig. 4 ein beispielhaftes Transientendiagramm eines Zählerwertes, wie er bei Ausführung des Verfahrens von Fig. 2 und Auftreten eines Ladestroms wie in Fig. 3 vorliegen könnte.

### Ausführliche Figurenbeschreibung

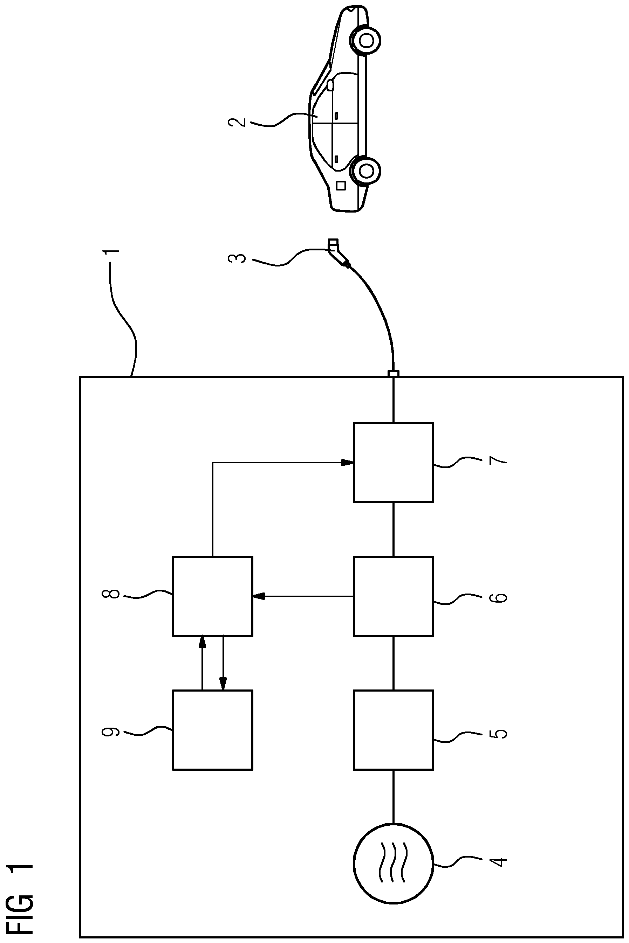

Fig. 1 zeigt ein Ausführungsbeispiel einer erfindungsgemäßen Ladevorrichtung 1, wobei die Ladevorrichtung 1 in Form eines Blockdiagramms dargestellt ist. Die Ladevorrichtung 1 kann mit einem Elektrofahrzeug 2 über einen Ladestecker 3 verbunden werden und wird selbst aus einem Versorgungsanschluss 4, der beispielsweise ein dreiphasiger Niederspannungsnetzanschluss sein kann, versorgt. Die Ladevorrichtung 1 weist einen Stromrichter 5 auf, der über den Versorgungsanschluss 4 mit elektrischer Energie versorgt wird und einen für das Laden des Elektrofahrzeugs 2 geeigneten Ladestrom erzeugt. Vorzugsweise ist die Ladevorrichtung als DC-Ladevorrichtung ausgebildet, das Elektrofahrzeug 2 mit einer Gleichspannung beziehungsweise einem Gleichstrom zu laden.

Zwischen den Stromrichter 5 und den Ladestecker 3 sind ein Stromsensor 6 und ein Schalter 7 in Reihe geschaltet, wobei vorliegend der Schalter 7 dem Stromsensor 6 nachgeschaltet ist. Der Stromsensor 6 ist mit einer Steuereinheit 8 verbunden, die von dem Stromsensor 6 gemessene und an die Steuereinheit 8 ausgegebene Strommesswerte empfangen und verarbeiten kann. Der Schalter 7 kann von der Steuereinheit 8 angesteuert und geöffnet oder geschlossen werden. Er dient dazu, den Ladestecker 3 abzutrennen, wenn ein Lichtbogenereignis von der Steuereinheit 8 detektiert wird und die Steuereinheit 8 infolge des Detektierens ein entsprechendes Steuersignal zum Öffnen des Schalters 7 an diesen ausgibt. Der Schalter 7 kann im Regelbetrieb auch außerhalb von Ladevorgängen dazu verwendet werden, den Ladestecker 3 elektrisch abzutrennen.

Die Steuereinheit 8 ist mit einem Zähler 9 verbunden dargestellt, wobei jedoch in den meisten Ausführungen der erfindungsgemäßen Ladevorrichtung 1 der Zähler 9 als Teil der Steuereinheit 8 oder als eine Variable eines Steuerprogramms implementiert sein wird. Der Zähler 9 kann im Betrieb von der Steuereinheit 8 inkrementiert oder dekrementiert werden. Sein Zählerwert wird bei Ausführungsformen der Erfindung mit Zähler 9 mit einem Zählerschwellwert verglichen, um darüber zu entscheiden, ob ein Lichtbogenereignis vorliegt oder nicht.

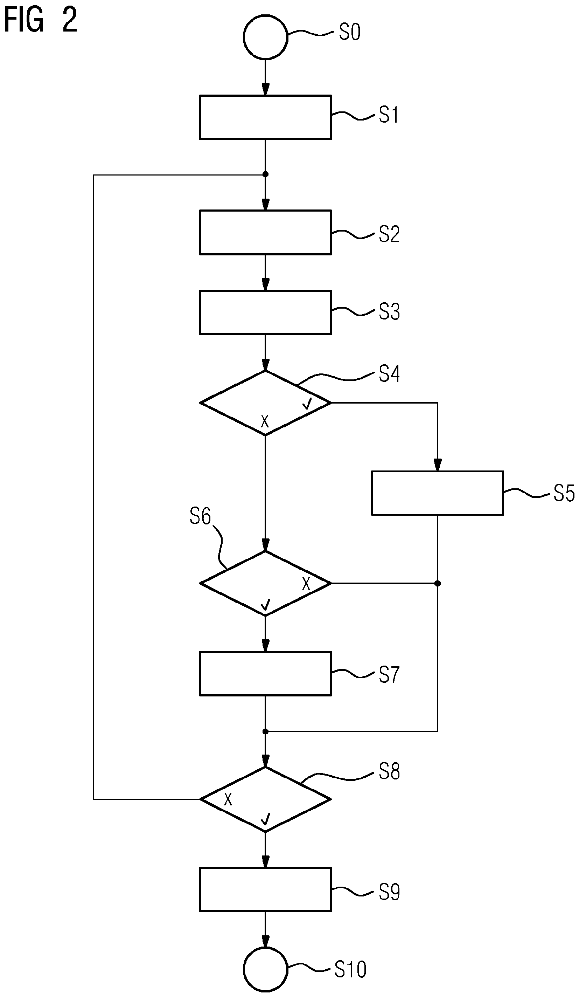

Fig. 2 zeigt ein Ausführungsbeispiel eines erfindungsgemäßen Verfahrens zum Laden eines Elektrofahrzeugs 2, das mit einem Startschritt S0 beginnt, wenn ein Ladevorgang für ein Elektrofahrzeug 2 begonnen wird. In einem nachfolgenden Schritt S1 wird ein gemäß einer Anforderung des Elektrofahrzeugs 2 bemessener Ladestrom ausgegeben. In Schritt S2 wird der an das Elektrofahrzeug 2 ausgegebene Ladestrom gemessen, um eine Reihe von Strommesswerten zu erhalten. Die Reihe von Strommesswerten wird im nachfolgenden Schritt S3 gefiltert, wobei verschiedene Filtercharakteristiken, gegebenenfalls in Kombination miteinander, zur Anwendung kommen können. Die Filterung dient dazu, die Zuverlässigkeit des Detektierens eines Lichtbogenereignisses zu erhöhen, ist jedoch optional. Beispielsweise kann das Filtern vorgesehen werden, um Oberwellen und durch Schaltvorgänge des Stromrichters 5 verursachte Schwankungen des Ladestroms zu unterdrücken.

In Schritt S4 wird geprüft, ob die Reihe von Strommesswerten eine Überschreitung und/oder eine Unterschreitung eines vorgegebenen Stromschwellwerts aufweist. Eine Überschreitung liegt beispielsweise dann vor, wenn die Strommesswerte von unterhalb des Stromschwellwerts auf oberhalb des Stromschwellwertes ansteigen. Eine Unterschreitung hingegen, wenn die Strommesswerte von oberhalb des Stromschwellwerts auf unterhalb des Stromschwellwerts abnehmen. Das Verfahren kann sowohl Überschreitungen als auch Unterschreitungen oder aber auch nur ein Kriterium der beiden genannten berücksichtigen.

Wird in Schritt S4 festgestellt, dass eine Überschreitung oder eine Unterschreitung vorliegt, wird nach Schritt S5 verzweigt, in dem ein Zähler inkrementiert wird. Lag hingegen keine Überschreitung oder Unterschreitung vor, wird mit Schritt S6 fortgefahren, in dem geprüft wird, ob eine vorgegebene Zeitspanne verstrichen ist, insbesondere verstrichen ist, ohne dass eine Überschreitung oder eine Unterschreitung festgestellt wurde. Kommt die Prüfung in Schritt S6 zu einem positiven Ergebnis, wird der Zähler in Schritt S7 dekrementiert, wobei vorzugsweise ein Unterlauf des Zählers vermieden wird, sollte der Zähler den Zählerwert null haben.

Nach dem Inkrementieren (Schritt S5) oder Dekrementieren (Schritt S7) des Zählers wird in Schritt S8 geprüft, ob der Zählerwert einen vorgegebenen Zählerschwellwert erreicht hat. Ist dies der Fall, so hat der Ladestrom in unerwarteter und unzulässiger Weise geschwankt, so dass auf das Vorliegen eines Lichtbogenereignisses geschlossen wird. Daraufhin wird in Schritt S9 der Ladestrom unterbrochen, was die erfindungsgemäß erwünschte Schutzfunktion des Ladesteckers 3, der Ladebuchse des Elektrofahrzeugs 2, allgemein der Ladevorrichtung 1 sowie der Umgebung bewirkt. In Schritt S9 kann zusätzlich ein Fehlersignal ausgegeben oder an eine entfernte Einrichtung wie eine Fernwartungszentrale ausgegeben werden, um die Notwendigkeit einer Wartungsmaßnahme anzuzeigen. Das erfindungsgemäße Verfahren endet anschließend in Schritt S10. Hat hingegen die Prüfung in Schritt S8 ergeben, dass der Zählerschwellwert nicht erreicht ist, wird der Ladevorgang fortgesetzt und zu Schritt S2 zurückverzweigt, bis der Ladevorgang nach Abgabe der gewünschten Energiemenge ordnungsgemäß beendet wird.

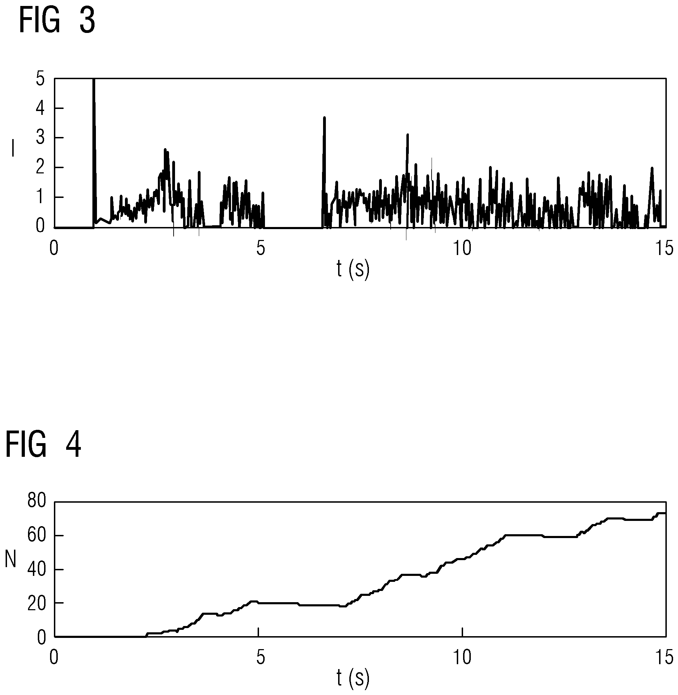

Fig. 3 zeigt ein beispielhaftes Transientendiagramm des an ein Elektrofahrzeug 2 abgegebenen Ladestroms I. Der Ladestrom I ist dabei über der Zeit t aufgetragen, die in Sekunden gemessen ist, und in seiner Größe normiert. Der Ladestrom I zeigt aufgrund des Vorliegens eines Lichtbogenereignisses starke Schwankungen und fällt zwischenzeitlich auf null, was ein zwischenzeitliches Zusammenbrechen des Lichtbogens zwischen Ladestecker 3 und Elektrofahrzeug 2 anzeigt. Nicht dargestellt, aber ebenso möglich sind Phasen, in denen der Ladestrom ungestört zum Elektrofahrzeug 2 fließt, da vorrübergehend ein ausreichend guter Kontakt zwischen Ladestecker 3 und Elektrofahrzeug 2 besteht.

Indem die Strommesswerte mit einem geeigneten Stromschwellwert verglichen werden, kann ein Lichtbogenereignis zuverlässig und einfach detektiert werden. Der gezeigte Ladestrom ist auf den Stromschwellwert normiert, so dass bei Überschreiten und/oder Unterschreiten des Wertes 1 im Diagramm der Zählerwert wie oben beschrieben inkrementiert wird.

Fig. 4 zeigt ein beispielhaftes Transientendiagramm eines Zählerwertes N, wie er bei Ausführung des Verfahrens von Fig. 2 und Auftreten eines Ladestroms wie in Fig. 3 vorliegen könnte. Der Zählerwert N ist erneut über der Zeit t aufgetragen, wobei eine der Fig. 3 entsprechende Skalierung gewählt wurde. Es zeigt sich, dass der Zählerwert N aufgrund der Schwankungen des Ladestroms I und der infolgedessen festgestellten über- und oder Unterschreitungen des Stromschwellwertes mit der Zeit ansteigt, wobei in Phasen, in denen der Ladestrom I nicht schwankt (weil unterbrochen oder ungestört fließend), der Zählerwert wieder langsam abfällt. Über die Zeit steigt der Zählerwert jedoch an, so dass bei weiterhin vorliegendem Lichtbogen schließlich der Zählerschwellwert erreicht und der Ladestrom wie oben beschrieben unterbrochen wird. Im gezeigten Beispiel könnte beispielsweise ein Zählerschwellwert von 80 gewählt werden, so dass das Lichtbogenereignis ungefähr zum Zeitpunkt t = 18 Sekunden detektiert und der Ladestrom unterbrochen wird.

Die Erfindung wurde unter Bezugnahme auf Abbildungen von bevorzugten Ausführungsbeispielen näher erläutert, soll durch diese jedoch nicht beschränkt werden. Vielmehr wird die Erfindung ausschließlich durch die nachfolgenden Patentansprüche definiert.

### Bezugszeichenliste

- 1: Ladevorrichtung
- 2: Elektrofahrzeug
- 3: Ladestecker
- 4: Versorgungsanschluss
- 5: Stromrichter
- 6: Stromsensor
- 7: Schalter
- 8: Steuereinheit
- 9: Zähler

## Patentansprüche

1. Eine Ladevorrichtung (1) für ein Elektrofahrzeug (2), die Ladevorrichtung (1) wenigstens umfassend einen Ladestecker (3), der ausgebildet ist, an das Elektrofahrzeug (2) angeschlossen zu werden, einen mit dem Ladestecker (3) und einem Versorgungsanschluss (4) der Ladevorrichtung (1) verbundenen Stromrichter (5), der ausgebildet ist, von dem Versorgungsanschluss (4) elektrische Energie zu empfangen und gemäß einer Anforderung des Elektrofahrzeugs (2) an den Ladestecker (3) auszugeben, einen zwischen den Stromrichter (5) und den Ladestecker (3) geschalteten Stromsensor (6), der ausgebildet ist, einen zwischen Stromrichter (5) und Ladestecker (3) fließenden Strom zu messen und als Strommesswert auszugeben, einen Schalter (7), der ausgebildet ist, den von dem Stromrichter (5) zum Ladestecker (3) fließenden Strom abzuschalten, und eine Steuereinheit (8), die mit dem Stromsensor (6) und dem Schalter (7) verbunden ist, **dadurch gekennzeichnet, dass** die Steuereinheit (8) dazu ausgebildet ist, ein Lichtbogenereignis anhand einer Reihe von Strommesswerten zu detektieren und bei Detektieren des Lichtbogenereignisses den Schalter (7) zum Abschalten des von dem Stromrichter (5) zum Ladestecker (3) fließenden Stroms anzusteuern.

2. Die Ladevorrichtung (1) des vorhergehenden Anspruchs, bei der die Steuereinheit (8) dazu ausgebildet ist, die Strommesswerte der Reihe von Strommesswerten mit einem Stromschwellwert zu vergleichen und das Lichtbogenereignis anhand einer Rate von Überschreitungen und/oder Unterschreitungen des Stromschwellwertes zu detektieren.

3. Die Ladevorrichtung (1) des vorhergehenden Anspruchs, bei der eine Überschreitung vorliegt, wenn ein vorrangehender Strommesswert der Reihe von Strommesswerten kleiner als der Stromschwellwert oder gleich dem Stromschwellwert ist und ein dem vorrangehenden Strommesswert der Reihe von Strommesswerten unmittelbar nachfolgender Strommesswert größer als der Stromschwellwert ist.

4. Die Ladevorrichtung (1) eines der Ansprüche 2 oder 3, bei der eine Unterschreitung vorliegt, wenn ein vorrangehender Strommesswert der Reihe von Strommesswerten größer als der Stromschwellwert oder gleich dem Stromschwellwert ist und ein dem vorrangehenden Strommesswert der Reihe von Strommesswerten unmittelbar nachfolgender Strommesswert kleiner als der Stromschwellwert ist.

5. Die Ladevorrichtung (1) eines der Ansprüche 2 bis 4, bei der die Steuereinheit dazu ausgebildet ist, das Lichtbogenereignis unter einer ersten Bedingung zu detektieren, wobei die erste Bedingung erfüllt ist, wenn die Reihe von Strommesswerten eine erste Anzahl von Überschreitungen und/oder Unterschreitungen des Stromschwellwertes innerhalb einer ersten Zeitspanne aufweisen.

6. Die Ladevorrichtung (1) des vorhergehenden Anspruchs, bei der die Steuereinheit (8) außerdem dazu ausgebildet ist, das Lichtbogenereignis unter einer zweiten Bedingung zu detektieren, wobei die zweite Bedingung erfüllt ist, wenn die Reihe von Strommesswerten eine von der ersten Anzahl verschiedene zweite Anzahl von Überschreitungen und/oder Unterschreitungen des Stromschwellwertes innerhalb einer von der ersten Zeitspanne verschiedenen zweiten Zeitspanne aufweisen.

7. Die Ladevorrichtung (1) der Ansprüche 5 und 6, bei der die Steuereinheit (8) dazu ausgebildet ist, das Lichtbogenereignis nur dann zu detektieren, wenn die erste Bedingung und die zweite Bedingung erfüllt sind.

8. Die Ladevorrichtung (1) eines der Ansprüche 2 bis 7, bei der die Steuereinheit (8) dazu ausgebildet ist, einen Zähler (9) bei einem Vorliegen einer Überschreitung und/oder einer Unterschreitung des Stromschwellwertes zu inkrementieren und den Zähler (9) nach Verstreichen einer vorbestimmten Zeitspanne zu dekrementieren, wobei die Steuereinheit (8) dazu ausgebildet ist, das Lichtbogenereignis zu detektieren, wenn der Zähler (9) einen Zählerschwellwert erreicht.

9. Die Ladevorrichtung (1) eines der Ansprüche 2 bis 8, mit einem zwischen Stromsensor (6) und Steuereinheit (8) geschalteten Filter, wobei das Filter dazu ausgebildet ist, von dem Stromsensor (6) Strommesswerte zu empfangen, die empfangenen Strommesswerte zu filtern und die gefilterten Strommesswerte an die Steuereinheit (8) auszugeben.

10. Die Ladevorrichtung (1) des vorhergehenden Anspruchs, bei dem das Filter eine Schalthysterese aufweist.

11. Ein Verfahren zum Laden eines Elektrofahrzeugs (2), mit den Schritten:
-- Messen eines an das Elektrofahrzeug (2) abgegebenen Ladestromes, um eine Reihe von Strommesswerten zu erhalten;
-- Detektieren eines Lichtbogenereignisses anhand der Reihe von Strommesswerten; und
-- Abschalten des Ladestromes, wenn ein Lichtbogenereignis detektiert wird.
